# EUROPEAN PATENT SPECIFICATION

(11) **EP 4 059 137 B1**
(45) Date of publication and mention of the grant of the patent: **11.03.2026**
(21) Application number: 19809006.0
(22) Date of filing: 18.11.2019
(51) Int. Cl.: H03H 9/02, H03H 9/205, H03H 9/56

(54) **BULK ACOUSTIC WAVE DEVICE WITH LATERALLY ACOUSTICALLY COUPLED RESONATORS**
AKUSTISCHE VOLUMENWELLENANORDNUNG MIT SEITLICH AKUSTISCH GEKOPPELTEN RESONATOREN
DISPOSITIF À ONDES ACOUSTIQUES DE VOLUME À RÉSONATEURS COUPLÉS ACOUSTIQUEMENT LATÉRALEMENT

(43) Date of publication of application: 21.09.2022
(73) Proprietor: Huawei Technologies Co., Ltd., Shenzhen, Guangdong 518129 (CN)
(72) Inventor: ERBES, Andreja, 80992 Munich (DE)
(74) Representative: Roth, Sebastian
(86) International application number: PCT/EP2019/081611
(87) International publication number: WO 2021/098938

(56) References cited:
- US-A1- 2004 124 952
- US-A1- 2013 214 878
- US-B1- 6 492 759
- DESVERGNE M ET AL: "Intermediate frequency lamb wave coupled resonator filters for RF receiver architectures", PROCEEDINGS OF THE EUROPEAN SOLID STATE DEVICE RESEARCH CONFERENCE (ESSDERC), no. 37TH, 2007, pages 358 - 361, XP002473840
- BI F Z ET AL: "Bulk acoustic wave RF technology", IEEE MICROWAVE MAGAZINE, IEEESERVICE CENTER, PISCATAWAY, NJ, US, vol. 9, no. 5, 2008, pages 65 - 80, XP011234158, ISSN: 1527-3342, DOI: 10.1109/MMM.2008.927633

## Description

### TECHNICAL FIELD

The present invention relates to acoustic wave devices, in particular to Bulk Acoustic Wave (BAW) devices and their fabrication method. The invention proposes a BAW device comprising at least a first BAW resonator and a second BAW resonator, which are acoustically coupled by using an acoustic coupling structure.

### BACKGROUND

Acoustic wave devices are key components for modern electronic circuits. In particular, high frequency selectivity, while maintaining low electronic insertion loss, requires high quality factor mechanical resonators coupled in a filter topology.

BAW resonators are configured to couple an electrical, time varying signal, to a mechanical wave traveling in the bulk of a piezoelectric material, i.e., they are configured to couple an electrical signal to a BAW. Conventional BAW resonators are produced using a thin piezoelectric layer, which is disposed over a reflective element. In the case of thin-film bulk acoustic resonators (FBAR), the reflective element is a cavity, while in the case of solidly mounted acoustic resonators (SMR), the reflective element is an acoustic mirror or Bragg reflector comprising alternating layers of high and low acoustic impedance materials.

The fundamental mode of vibration, which a BAW resonator can electromechanically couple to, is the thickness-extensional (TE) mode. This mode bases on longitudinal waves that propagate in the thickness of the thin piezoelectric material.

However, in addition to the desired TE mode, also lateral plate modes (lateral Rayleigh-Lamb waves) may be triggered, which are generated in the same structure. Such lateral modes have wave-vectors k, which are orthogonal to the longitudinal TE modes, and are highly sensitive to the boundary condition(s) in the (x, y) plane of the BAW resonator stack.

In addition to a degradation of the pass-band ripple, when such BAW resonators are arranged in a filter topology (e.g. ladder, lattice combination), these lateral modes also couple to the fundamental TE modes, and thereby reduce the quality factor Q of the BAW resonator. The energy of the Rayleigh-Lamb modes are not confined to the piezoelectric layer, and usually escape the resonant cavity, leading to a path of energy reduction and ultimately, to a degradation in Q.

The lateral modes are conventionally a disadvantage of BAW resonators, and negatively affect in particular the power handling of BAW resonator devices. However, power handling of micro-resonators is becoming more and more critical, due to the large operating RF power, which front-end filters experience during their nominal operation.

US 2013/214878 discloses an acoustic wave bandpass filter comprising at least one photonic crystal structure to guide acoustic waves. US 6 492 759 B1 discloses a piezoelectric resonator and a filter.

### SUMMARY

In view of the above-mentioned disadvantages, embodiments of the present invention aim to improve conventional BAW resonator devices. An objective is in particular to provide a BAW (resonator) device that enables improved power handling.

The objective is achieved by the embodiments of the invention as described in the enclosed independent claims. Advantageous implementations of the embodiments of the invention are further defined in the dependent claims. In the following, parts of the description and drawings referring to embodiments not covered by the claims, are not part of the invention, but are illustrative examples necessary for understanding the invention.

The embodiments of the invention base on the recognition of the inventors that the lateral modes can be used for an advantage. In particular, an optimization of lateral traveling waves enables an acoustic coupling of adjacent BAW resonators operating in their fundamental TE mode (or in a thickness-shear (TS) mode). The main modes of the BAW may include TE modes, TS modes, or both TE and TS modes.

In the below description, explanations made with reference to TE modes apply similarly to TS modes, and vice versa. Hence the terms "longitudinal" and "shear" can be interchanged depending on the fundamental mode of the BAW.

Electrical coupling of adjacent BAW resonators is usually subject to phase-mismatch, due to manufacturing tolerances of identically designed resonators. However, in the embodiments of the invention, an acoustic/mechanical coupling is provided that ensures synchronicity of the adjacent coupled BAW resonators, and thus improve the power handling. In order to enable the acoustic coupling between the BAW resonators, a coupling structure is provided and added between the BAW resonators, wherein the coupling structure allows for lateral traveling waves to occur.

In embodiments of the invention, adjacent BAW resonators (in a BAW device) form a mechanically and acoustically coupled system, which allows two or more new fundamental modes of operation to exist. The proper engineering of the acoustic coupling structure arranged between the adjacent BAW resonators can either increase or decrease the coupling strength, and can thereby modify the overall coupled dynamics of the BAW resonator system.

The mechanically coupled BAW resonators ensure that, at a given mode of vibration, the BAW resonators follow a synchronicity that is defined by a particular eigenmode triggered. In that case, it is possible to engineer the coupling such that a current generated from the piezoelectric effect of the vibrating BAWs are in phase throughout the coupled system.

A first aspect of the invention provides a BAW device, comprising: a piezoelectric layer configured to propagate a BAW; a first bottom electrode and a second bottom electrode provided beneath the piezoelectric layer, respectively; a first top electrode and a second top electrode provided on the piezoelectric layer, respectively, wherein the first top electrode and the first bottom electrode sandwich the piezoelectric layer to form a first BAW resonator, the first BAW resonator comprising a first resonator region, which is a region of the piezoelectric layer located between the first top electrode and the first bottom electrode, and wherein the second top electrode and the second bottom electrode sandwich the piezoelectric layer to form a second BAW resonator, the second BAW resonator comprising a second resonator region, which is a region of the piezoelectric layer located between the second top electrode and the second bottom electrode; the BAW device further comprising: an acoustic coupling structure arranged between the first top electrode and the second top electrode on the piezoelectric layer, wherein the acoustic coupling structure is configured to allow an acoustic wave to propagate from the first resonator region into the second resonator region through the acoustic coupling structure, and wherein the acoustic coupling structure comprises a plurality of material layers arranged on top of each other.

The acoustic coupling structure also allows propagation in the inverse direction. That is, the acoustic coupling structure also allows an acoustic wave to propagate from the second resonator region into the first resonator region.

In one embodiment, the first bottom electrode and the second bottom electrode are a first region and a second region of a single metal layer. In another embodiment, the first bottom electrode and the second bottom electrode are formed as two separate, adjacent metal layers.

In the BAW device of the first aspect, the two BAW resonators are coupled, via the acoustic coupling structure, based on lateral traveling waves, i.e., employing the lateral modes mentioned above. Thus, these, usually unwanted, lateral modes are now turned into an advantage, namely providing the acoustic coupling between the BAW resonators. This can ensure synchronicity of the coupled BAW resonators, and thus improve the power handling of the BAW device. Accordingly, an improved BAW resonator device is provided.

In an implementation form of the first aspect, a mass loading layer and/or a passivation layer is provided on the first top electrode and on the second top electrode to respectively form a first BAW stack and a second BAW stack, and the acoustic coupling structure protrudes from between the first top electrode and the second top electrode in an upward direction.

In an implementation form of the first aspect, a mass loading layer and/or a passivation layer is provided on the first top electrode and on the second top electrode to respectively form a first BAW stack and a second BAW stack, and the acoustic coupling structure is recessed between the first top electrode and the second top electrode.

The mass loading layer can be used to change the vibration characteristics of the piezoelectric layer. The passivation layer protects the BAW resonators.

In an implementation form of the first aspect, a thickness and/or a width of the acoustic coupling structure are selected such that the lateral BAW has one or more determined lateral plate modes.

In this way, the coupling between the adjacent BAW resonators can be tailored.

In an implementation form of the first aspect, the BAW device further comprises: an acoustic reflective element located below the top electrodes, the piezoelectric layer, and the bottom electrodes.

In an implementation form of the first aspect, the acoustic reflective element comprises a plurality of high and low acoustic impedance layers, which form a Bragg mirror structure.

In an implementation form of the first aspect, the acoustic reflective element comprises a cavity.

A second aspect of the disclosure provides a method for fabricating a BAW, device, the method comprising: providing a piezoelectric layer configured to propagate a BAW; forming a first bottom electrode and a second bottom electrode beneath the piezoelectric layer, respectively; and forming a first top electrode and a second top electrode on the piezoelectric layer, respectively, wherein the first top electrode and the first bottom electrode sandwich the piezoelectric layer to form a first BAW resonator, the first BAW resonator comprising a first resonator region, which is a region of the piezoelectric layer located between the first top electrode and the first bottom electrode, and wherein the second top electrode and the second bottom electrode sandwich the piezoelectric layer to form a second BAW resonator, the second BAW resonator comprising a second resonator region, which is a region of the piezoelectric layer located between the second top electrode and the second bottom electrode; the method further comprising: forming an acoustic coupling structure between the first top electrode and the second top electrode on the piezoelectric layer, wherein the acoustic coupling structure allows an acoustic wave to propagate from the first resonator region into the second resonator region through the acoustic coupling structure, and wherein the acoustic coupling structure is formed by arranging a plurality of material layers on top of each other.

The method of the second aspect can be developed with further implementation forms according to the implementation forms of the first aspect. That is, in implementation forms of the method of the second aspect, further elements of the BAW device - as described in the implementation forms of the first aspect - can be provided and/or formed and/or fabricated.

The method of the second aspect and its respective implementation forms provide the same advantages as the BAW device of the first aspect and its implementation forms.

It has to be noted that all devices, elements, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof.

### BRIEF DESCRIPTION OF DRAWINGS

The above described aspects and implementation forms (embodiments) of the invention will be explained in the following description of specific embodiments in relation to the enclosed drawings, in which
- FIG. 1: shows a BAW device according to an embodiment of the invention.
- FIG. 2: shows a BAW device according to an example with an acoustic coupling structure comprising embedded material elements on the piezoelectric layer, and with a Bragg mirror structure.
- FIG. 3: shows a BAW device according to an example with an acoustic coupling structure comprising embedded material elements on the piezoelectric layer and an intermediate layer beneath the piezoelectric layer, and with a Bragg mirror structure.
- FIG. 4: shows a BAW device according to an example with an acoustic coupling structure comprising embedded material elements above the piezoelectric layer, and with a Bragg mirror structure.
- FIG. 5: shows a BAW device according to an example with an acoustic coupling structure comprising embedded material elements above the piezoelectric layer, and with a Bragg mirror structure.
- FIG. 6: shows a BAW device according to an example with an acoustic coupling structure comprising material elements on an additional material layer, and with a Bragg mirror structure.
- FIG. 7: shows a BAW device according to an embodiment of the invention with a protruding acoustic coupling structure comprising a plurality of material layers, and with a Bragg mirror structure.
- FIG. 8: shows a BAW device according to an embodiment of the invention with a recessed acoustic coupling structure comprising a plurality of material layers, and with a Bragg mirror structure.
- FIG. 9: shows a BAW device according to an example with an acoustic coupling structure comprising embedded material elements on the piezoelectric layer, and with a plurality of cavities as reflective elements.
- FIG. 10: shows a BAW device according to an example with an acoustic coupling structure comprising embedded material elements on the piezoelectric layer, and with a cavity as reflective element.
- FIG. 11: shows a method for forming a BAW device according to an embodiment of the invention.

### DETAILED DESCRIPTION OF EMBODIMENTS

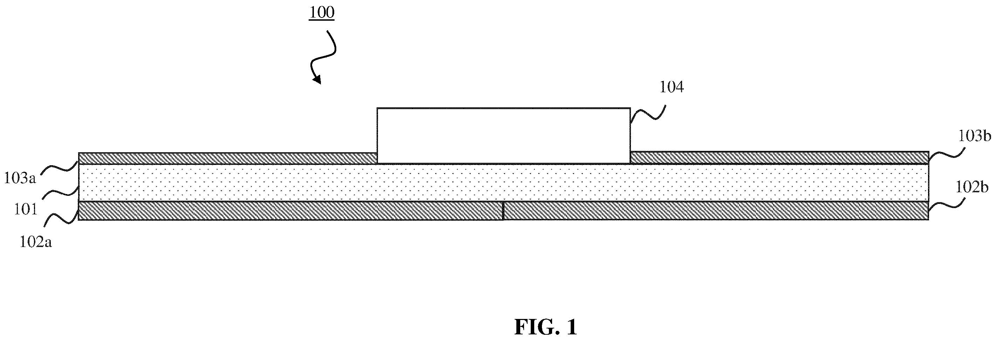

FIG. 1 shows a BAW device 100 according to an embodiment of the invention. The BAW device 100 can also be referred to as a BAW resonator device 100, since it includes multiple BAW resonators. The BAW device 100 is shown in a cross-section (wherein a height of the BAW device 100 is shown from bottom to top, and a width/lateral extension of the BAW device 100 is shown from left to right).

In particular, the BAW device 100 comprises a piezoelectric layer 101. The piezoelectric layer 101 is configured to propagate a BAW. The piezoelectric layer 101 is thus at the core of each BAW resonator of the BAW device 100. The piezoelectric layer 101 can be common to more or all BAW resonators of the BAW device 100, as it is illustrated in FIG. 1.

Further, the BAW device 100 comprises a first bottom electrode 102a and a second bottom electrode 102b, both of which are provided beneath the piezoelectric layer 101. Notably, the first bottom electrode 102a and the second bottom electrode 102b may be a first region and a second region of a single (e.g. metal) layer. Alternatively, the first bottom electrode 102a and the second bottom electrode 102b may be formed as two separate, adjacent (e.g. metal) layers.

The BAW device 100 also comprises a first top electrode 103a and a second top electrode 103b, both provided on the piezoelectric layer 101, respectively. The first top electrode 103a and the first bottom electrode 102a sandwich the piezoelectric layer 101 to form a first BAW resonator, wherein the first BAW resonator comprises a first resonator region, which is a region of the piezoelectric layer 101 located between the first top electrode 103a and the first bottom electrode 102a. Likewise, the second top electrode 103b and the second bottom electrode 102b also sandwich the piezoelectric layer 101 to form a second BAW resonator, wherein the second BAW resonator comprises a second resonator region, which is a region of the piezoelectric layer 101 located between the second top electrode 103b and the second bottom electrode 102b. The first and second top and bottom electrodes 102a, 102b, 103a, 103b are configured to couple an electrical signal to a BAW propagating in the piezoelectric layer 101, particularly in the respective resonator region. The first BAW resonator is adjacent to the second BAW resonator in the BAW device 100.

The BAW device 100 further comprises an acoustic coupling structure 104 arranged between the first top electrode 103a and the second top electrode 103b on the piezoelectric layer 101. The first top electrode 103a and the second top electrode 103b, which are provided on the piezoelectric layer 101, are thus separated from another, laterally, by the acoustic coupling structure 104 arranged also on the piezoelectric layer 101. The acoustic coupling structure 104 is configured to allow an acoustic wave, in particular lateral wave/modes, to propagate from the first resonator region into the second resonator region, in particular in the piezoelectric layer 101, through the acoustic coupling structure 104, and vice versa, i.e. from the second resonator region into the first resonator region.

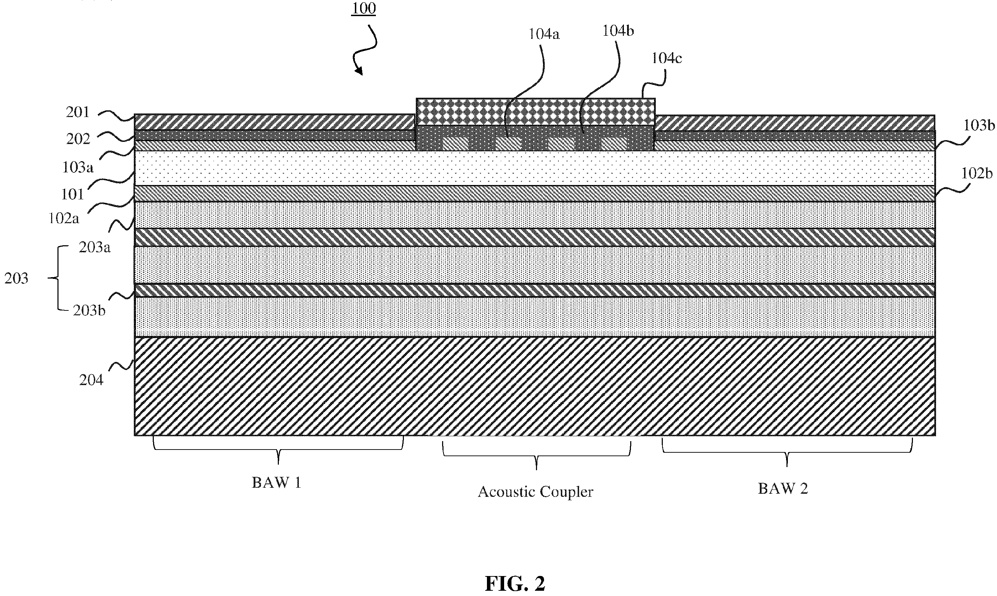

FIG. 2 shows an example of the BAW device 100, which bases on the embodiment of the BAW device 100 shown in FIG. 1. Accordingly, same elements in FIG. 1 and FIG. 2 are labelled with the same reference signs and function likewise. The BAW device 100 shown in FIG. 2 comprises further, optional, elements. The BAW device 100 is shown in a cross-section.

In particular, in the BAW device 100 shown in FIG. 2, two adjacent BAW resonators (indicated by "BAW 1" and "BAW 2") are provided, which are laterally (i.e., in plane of the piezoelectric layer 101) coupled by the acoustic coupling structure 104 (also indicated by "Acoustic Coupler"). The BAW resonators are exemplarily provided in a SMR configuration, wherein a Bragg mirror structure is provided as acoustic reflective element 203 is located below the top electrodes 103a and 103b, the piezoelectric layer 101, and the bottom electrodes 102b and, 102b. The acoustic reflective element 203 accordingly comprises Bragg layers 203a and 203b, which form an acoustic mirror (with a 1^{st} material for layer(s) 203a, and a 2^{nd} material for layer(s) 203b). In particular, a plurality of high impedance layers 203a and low impedance layers 203b form the Bragg mirror structure. The 1^{st} material may, e.g., be SiO₂, and the 2^{nd} material may, e.g., be W, and these materials may form the alternating high/low acoustic impedance layers 203a/20b forming the Bragg mirror. Below the acoustic reflective element 203 is usually, as shown, the substrate/bulk material 204.

FIG. 2 shows an exemplary cross-section of the acoustic coupling structure 104. The acoustic coupling structures 104 comprises two or more material elements 104 (comprising a 3^{rd} material, e.g., a metal, e.g., comprising the same material/metal as the top electrodes 103a and 103b; and/or the same material/metal as the bottom electrodes 102a and 102b), which are deposited over the piezoelectric layer 101, particularly are provided on the top surface of the piezoelectric layer 101.

Here an additional material layer 104b is deposited on the piezoelectric layer 101. Thus, the material elements 104a are included in, particularly embedded into, the additional material layer 104b (comprising, e.g., a 4^{th} material). The two or more embedded material elements 104a usually have acoustic and/or material properties different from those of the surrounding 4^{th} material of the additional material layer 104b. Further, a passivation layer or a mass loading layer 104c (comprising a 5^{th} material) may be deposited on the additional material layer 104b. That layer 104c can, for instance, be used to tune the wave-dispersion characteristics of the acoustic coupling structure 104.

On the first top electrode 103a and/or the second top electrode 103b, a mass loading layer 202 and/or a passivation layer 201 may be provided. In FIG. 2 both of those are provided, as an example, wherein the mass loading layer 202 is specifically provided on the top electrodes 103a and 103b, and the passivation layer 201 is provided on the mass loading layer 202. The mass loading layer 202 may comprise the same 4^{th} material as the additional material layer 104b of the acoustic coupling structure 104.

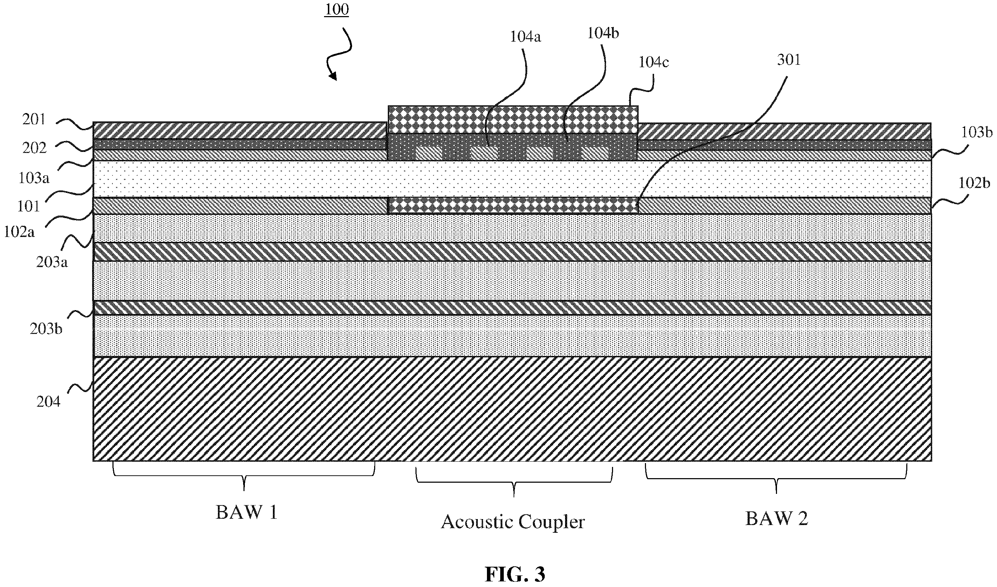

FIG. 3 shows an example of the BAW device 100, which bases on the example of the BAW device 100 shown in FIG. 2. Accordingly, same elements in FIG. 2 and FIG. 3 are labelled with the same reference signs and function likewise. The BAW device 100 shown in FIG. 3 comprises further or other, optional, elements. The BAW device 100 is again shown in the cross-section.

In particular, the BAW device 100 shown in FIG. 3 includes an intermediated material layer 301, which is provided beneath the piezoelectric layer 101 between the first bottom electrode 102a and the second bottom electrode 102b. In particular, in this case the intermediate material layer 301 separates the first bottom electrode 102a, laterally, from the second bottom electrode 102b. The intermediate material layer 301 may thereby have the same width (i.e., lateral extension) than the acoustic coupling structure 104, as it is shown in FIG. 3. The intermediate layer 301 may comprise the same 5^{th} material as the mass loading layer 104c of the acoustic coupling structure 104. The intermediate material layer 301 functions, in particular, together with the acoustic coupling structure 104 to allow an acoustic wave to propagate from the first resonator region into the second resonator region and vice versa. The coupling can be improved by the intermediate material layer 301.

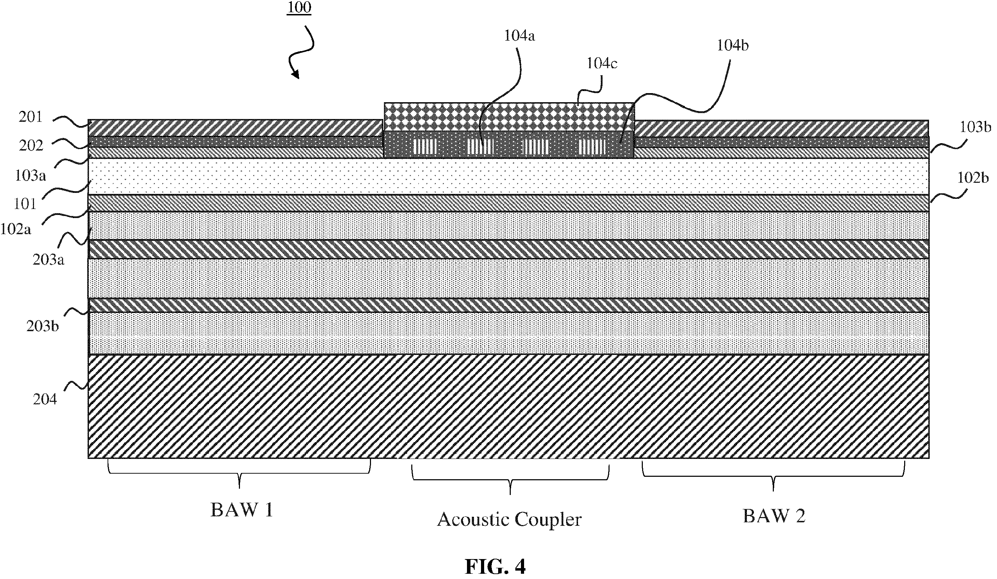

FIG. 4 shows an example of the BAW device 100, which bases on the BAW device 100 shown in FIG. 1 and FIG. 2. Accordingly, same elements in FIG. 2 and FIG. 4 are labelled with the same reference signs and function likewise. The BAW device 100 shown in FIG. 4 comprises further, optional, elements. The BAW device 100 is again shown in the cross-section.

In particular, the BAW device 100 shown in FIG. 4 has a similar structure as shown in FIG. 2, but now the material elements 104a, in particular being periodically replicated material elements 104a, (here exemplarily made from a 6^{th} material, which is different from the material of the top/bottom electrodes 102a and 103b) are not deposited directly on the top surface of the piezoelectric layer 101, but are elevated above the surface of the piezoelectric layer 101, and are embedded into the additional material layer 104c.

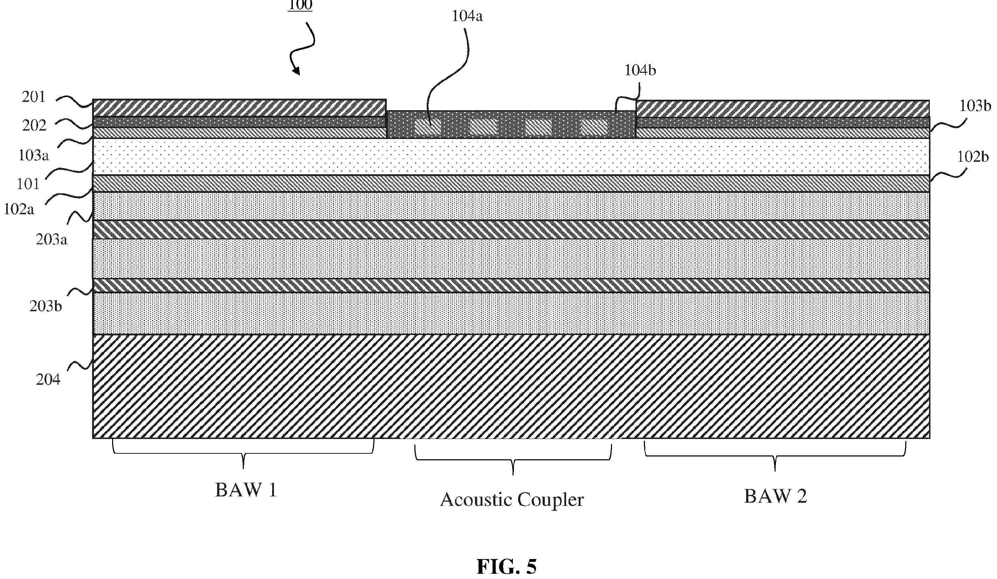

FIG. 5 shows an example of the BAW device 100, which bases on the BAW device 100 shown in FIG. 1 and FIG. 2. Accordingly, same elements in FIG. 2 and FIG. 5 are labelled with the same reference signs and function likewise. The BAW device 100 shown in FIG. 5 comprises further or other, optional, elements. The BAW device 100 is again shown in the cross-section.

In particular, the BAW device 100 shown in FIG. 5 has a similar structure as shown in FIG: 2, but now no mass loading layer 104c is provided on the additional material layer 104b. The thickness (height) of the additional material layer 104b is smaller than the thickness (height) of the adjacent BAW stack(s) formed respectively by the top electrodes 103a and 103b, the mass loading layer 202, and the passivation layer 201. In particular, while as shown in FIG. 2 the acoustic coupling structure 104 may generally protrude from between the first top electrode 103a and the second top electrode 103b in a upward direction (i.e. away from the piezoelectric layer 101), as shown in FIG. 3 the acoustic coupling structure 104 may generally also be recessed between the first top electrode 103a and the second top electrode 103b.

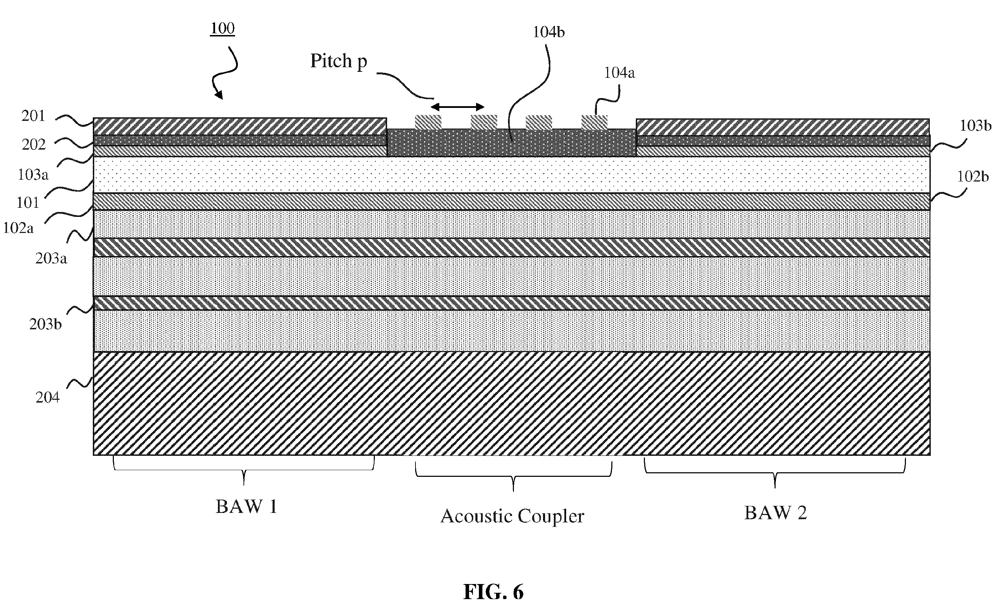

FIG. 6 shows an example of the BAW device 100, which bases on the BAW device 100 shown in FIG. 1 and FIG. 5. Accordingly, same elements in FIG. 5 and FIG. 6 are labelled with the same reference signs and function likewise. The BAW device 100 shown in FIG. 6 comprises further or other, optional, elements. The BAW device 100 is again shown in the cross-section.

In particular, the BAW device 100 shown in FIG. 6 has a similar structure as shown in FIG. 5, however, the material elements 104a are provide on the additional material layer 104b, instead of embedded into the additional material layer 104b as shown in FIG. 5. The two or more material elements 104a may have acoustic and/or material properties different from those of the material of the additional material layer 104c.

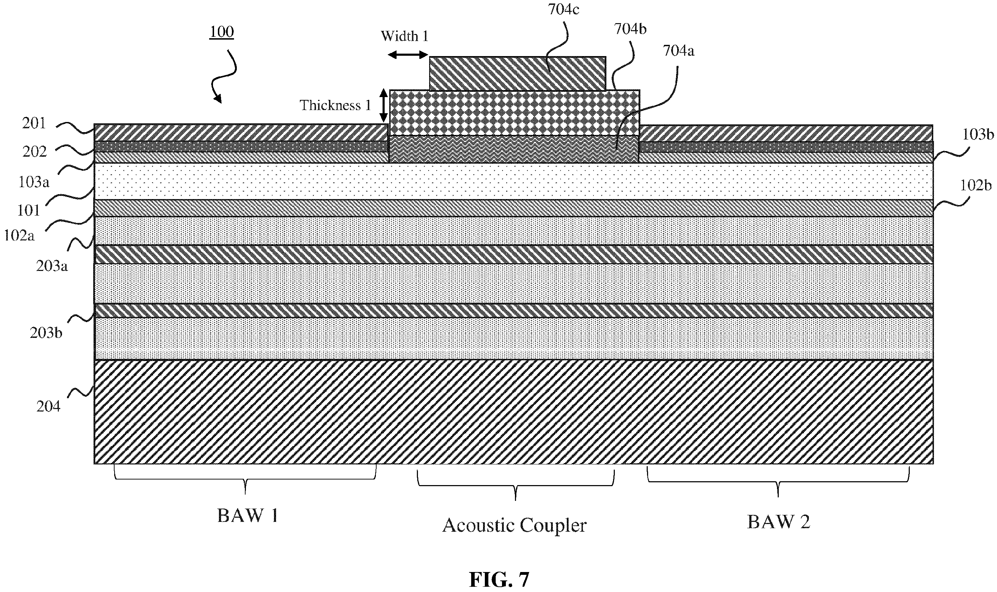

FIG. 7 shows an embodiment of the BAW device 100, which bases on the BAW device 100 shown in FIG. 1 and FIG. 2. Accordingly, same elements in FIG. 2 and FIG. 6 are labelled with the same reference signs and function likewise. The BAW device 100 shown in FIG. 6 comprises further or other, optional, elements. The BAW device 100 is again shown in the cross-section.

In particular, in the BAW device 100 shown in FIG. 6, the acoustic coupling structure 104 is different to the acoustic coupling structure 104 shown in FIG. 2. In this case of FIG. 6, the acoustic coupling structure 104 is composed of deposited material regions/layers (here three layers 704a, 704b, and 704c). In particular, the acoustic coupling structure 104 comprises a plurality of material layers 704a, 704b, and 704c arranged on top of each other. The material layer 704a may comprise a 7^{th} material, while the material layer 704b ma comprise the 5^{th} material and the material layer 704c may comprise the 2^{nd} material.

A total thickness of the acoustic coupling structure 104, i.e., of the material layers 704a, 704b and 704c, may exceed that of the adjacent BAW stack(s) (top electrodes 102a and 102b, mass loading layer 202, and passivation layer 201). A width of the material layer 704c may be smaller than a width of the material layer 704b and/or of the material layer 704a. A thickness of the material layer 704b may be larger than a thickness of the material layer 704a. In the BAW device 100 of FIG7, the shown acoustic coupling structure 104 has a "frame" or "fence" configuration.

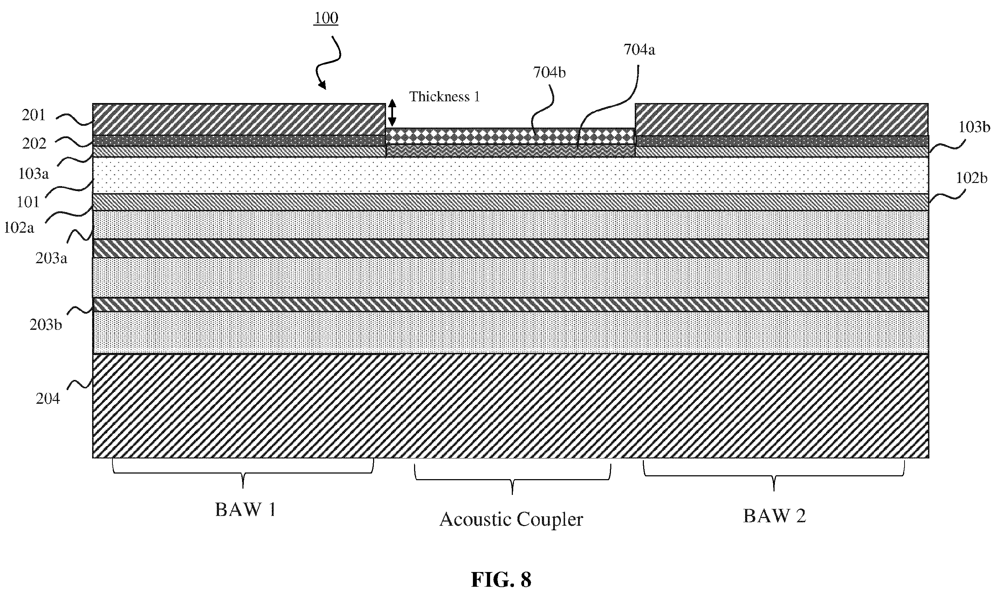

FIG. 8 shows an embodiment of the BAW device 100, which bases on the embodiment of the BAW device 100 shown in FIG. 1 and FIG. 7. Accordingly, same elements in FIG. 7 and FIG. 8 are labelled with the same reference signs and function likewise. The BAW device 100 shown in FIG. 8 comprises further or other, optional, elements. The BAW device 100 is again shown in the cross-section.

In particular, the BAW device 100 shown in FIG. 8 has an acoustic coupling structure 104 comprising, similarly as shown in FIG. 7, a plurality of material layers (here only the two layers 704a and 704b), however, the acoustic coupling structure 104 forms a "recessed" region, i.e., its total thickness is smaller than that of the adjacent BAW stack(s).

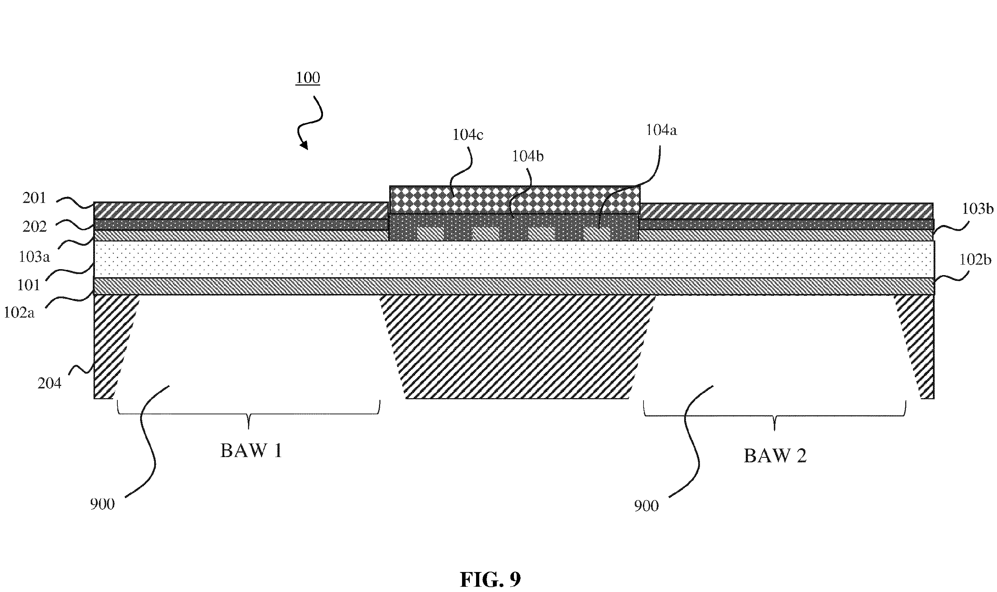

FIG. 9 shows an example of the BAW device 100, which bases on the BAW device 100 shown in FIG. 1 and FIG. 2. Accordingly, same elements in FIG. 2 and FIG. 9 are labelled with the same reference signs and function likewise. The BAW device 100 shown in FIG. 9 comprises further and/or other, optional, elements. The BAW device 100 is again shown in the cross-section.

In particular, the BAW device 100 shown in FIG. 9 comprises a thin-film bulk acoustic wave configuration (i.e. Film Bulk Acoustic wave Resonator (FBAR) configuration). The acoustic reflective element 203 now comprises a cavity 900, in particular an etched cavity 900, rather than the Bragg mirror structure shown in FIG. 2. Specifically, the BAW device 100 shown in FIG. 9 comprises two cavities 900, each cavity 900 formed beneath one of the BAW resonators, but comprises bulk material 204 beneath the acoustic coupling structure 104. That is, the two cavities 900 are laterally separated by the bulk material 204. The shown acoustic coupling structure 104 is similarly formed as in FIG. 2, but can also be formed as in any of FIG. 3 - FIG. 8.

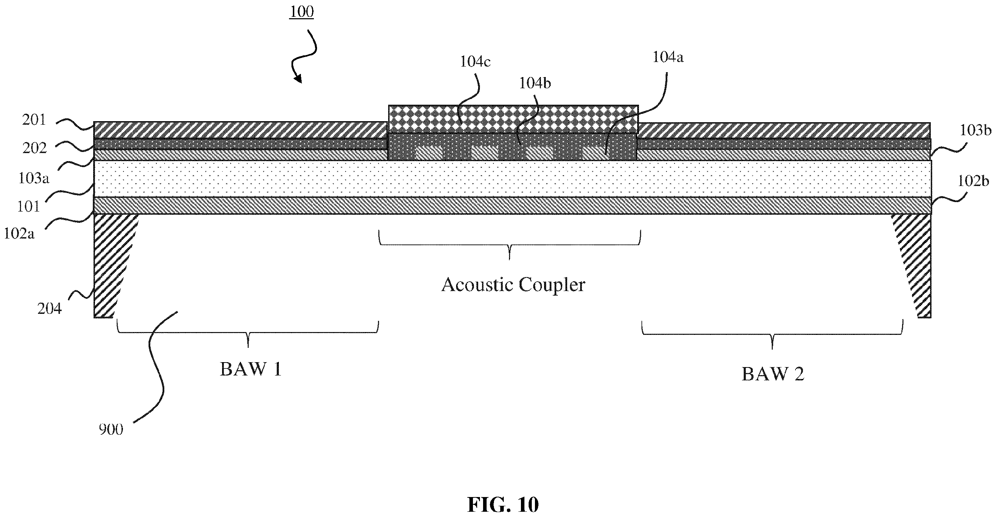

FIG. 10 shows an example of the BAW device 100, which bases on the BAW device 100 shown in FIG. 1 and FIG. 9. Accordingly, same elements in FIG. 9 and FIG. 10 are labelled with the same reference signs and function likewise. The BAW device 100 shown in FIG. 10 comprises further and/or other, optional, elements. The BAW device 100 is again shown in the cross-section.

In particular, the BAW device 100 shown in FIG. 10 comprises one cavity 900 provided beneath the first and second BAW resonators and the acoustic coupling structure 104, respectively.

In either one of the above-described embodiments and examples of the BAW device 100, i.e. in any BAW device 100 as shown in FIG. 1 - FIG. 10, the following material selection(s) is/are possible.

The substrate (bulk material 204) may be one of silicon, glass, ceramic, and the like. In an example, the substrate 204 can include silicon, a SOI technology substrate, gallium arsenide, gallium phosphide, gallium nitride, and/or indium phosphide or other example substrate, an alloy semiconductor including GaAsP, AlInAs, GaInAs, GaInP, or GaInAsP or combinations thereof.

The (e.g., thin film) piezoelectric layer 101 may be one of lithium niobate, lithium tantalate, and the like.

In an example, the material elements 104a of the acoustic coupling structure 104 may comprise a dielectric material. For example, the dielectric material can include SiCOH. a phosphosilicate glass, an oxide or a nitride of aluminum, silicon, germanium, gallium, indium, tin, antimony, tellurium, bismuth, titanium, vanadium, chromium, manganese, cobalt, nickel, copper, zinc, zirconium, niobium, molybdenum, palladium, cadmium, hafnium, tantalum, or tungsten, or any combination thereof.

The metallization layers, in particular the material (e.g., the 3^{rd} material) of the electrodes 102a, 102b, 103a and/or 103b, may be a metal and/or metal alloy layer, or may be a highly doped silicon layer may. In particular, it may include, for example, copper, aluminum, tungsten, titanium, etc. The BEOL dielectric layers may include, for example, copper capping layers (CCL), etch stop layers (ESL), diffusion barriers (DB), antireflection coating (ARC) and low-k dielectrics such as, for example, SiCOH, SiOCN, SiCN, SiOC, SiN. The materials available in the CMOS BEOL layers include, for example, copper metallization, tungsten, low-k dielectrics, silicon dioxides, copper capping layers, etch stop layers, anti-reflecting coatings, etc.

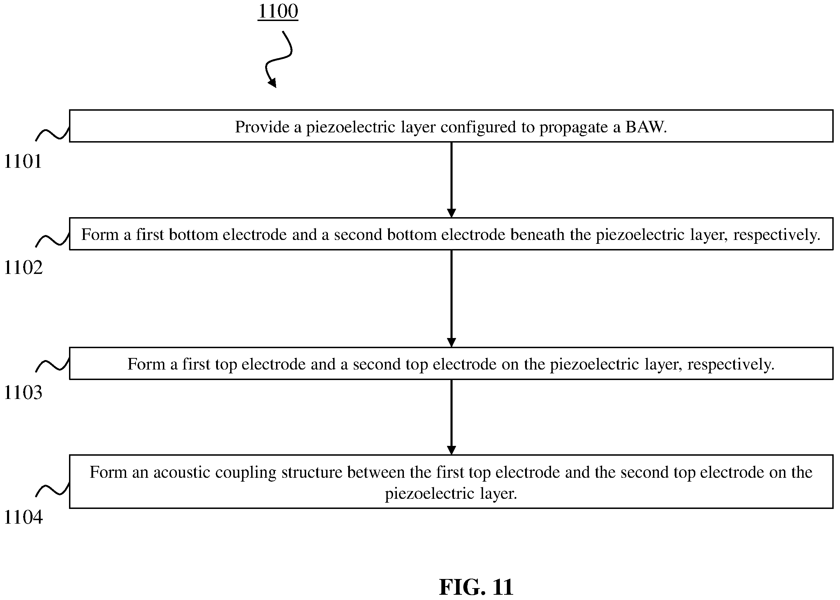

FIG. 11 shows a method 1100 for fabricating a BAW device 100. In particular, a BAW device 100 as shown in FIG. - FIG. 10 can be fabricated by the method 1100.

The method 1100 comprises as step 1101 of providing a piezoelectric layer 101 configured to propagate a BAW.

The method 1100 further comprises a step 1102 of forming a first bottom electrode 102a and a second bottom electrode 102b beneath the piezoelectric layer 101, respectively.

The method 1100 further comprises a step 1103 of forming a first top electrode 103a and a second top electrode 103b on the piezoelectric layer 101, respectively. The first top electrode 102a and the first bottom electrode 102b sandwich the piezoelectric layer 101 to form a first BAW resonator, the first BAW resonator comprising a first resonator region, which is a region of the piezoelectric layer 101 located between the first top electrode 103a and the first bottom electrode 102. The second top electrode 103b and the second bottom electrode 102b sandwich the piezoelectric layer 101 to form a second BAW resonator, the second BAW resonator comprising a second resonator region, which is a region of the piezoelectric layer 101 located between the second top electrode 103b and the second bottom electrode 102b; the method 1100 further comprising: forming 1103 an acoustic coupling structure 104 between the first top electrode 103a and the second top electrode 103b on the piezoelectric layer 101, wherein the acoustic coupling structure 104 allows an acoustic wave to propagate from the first resonator region into the second resonator region through the acoustic coupling structure 104.

The present invention has been described in conjunction with various embodiments as examples as well as implementations. However, other variations can be understood and effected by those persons skilled in the art and practicing the claimed invention, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A Bulk Acoustic Wave, BAW, device (100), comprising:
a piezoelectric layer (101) configured to propagate a BAW;
a first bottom electrode (102a) and a second bottom electrode (102b) provided beneath the piezoelectric layer (101), respectively;
a first top electrode (103a) and a second top electrode (103b) provided on the piezoelectric layer (101), respectively,
wherein the first top electrode (103a) and the first bottom electrode (102a) sandwich the piezoelectric layer (101) to form a first BAW resonator, the first BAW resonator comprising a first resonator region, which is a region of the piezoelectric layer (101) located between the first top electrode (103a) and the first bottom electrode (102a), and
wherein the second top electrode (103b) and the second bottom electrode (102b) sandwich the piezoelectric layer (101) to form a second BAW resonator, the second BAW resonator comprising a second resonator region, which is a region of the piezoelectric layer (101) located between the second top electrode (103b) and the second bottom electrode (102b);
the BAW device (100) further comprising:
an acoustic coupling structure (104) arranged between the first top electrode (103a) and the second top electrode (103b) on the piezoelectric layer (101),
wherein the acoustic coupling structure (104) is configured to allow an acoustic wave to propagate from the first resonator region into the second resonator region through the acoustic coupling structure (104), and
the BAW device (100) being **characterized in that** the acoustic coupling structure (104) comprises a plurality of material layers (704a, 704b, 704c) arranged on top of each other.

2. The BAW device (100) according to claim 1, wherein:
a mass loading layer (202) and/or a passivation layer (201) is provided on the first top electrode (103a) and on the second top electrode (103b) to respectively form a first BAW stack (103a, 201, 202) and a second BAW stack (103b, 201, 202); and
the acoustic coupling structure (104) protrudes from between the first BAW stack (103a, 201, 202) and the second BAW stack (103b, 201, 202) in an upward direction.

3. The BAW device (100) according to claim 1, wherein:
a mass loading layer (202) and/or a passivation layer (201) is provided on the first top electrode (103a) and on the second top electrode (103b) to respectively form a first BAW stack (103a, 201, 202) and a second BAW stack (103b, 201, 202); and
the acoustic coupling structure (104) is recessed between the first BAW stack (103a, 201, 202) and the second BAW stack (103b, 201, 202).

4. The BAW device (100) according to one of the claims 1 to 3, wherein:
a thickness and/or a width of the acoustic coupling structure (104) are selected such that the lateral BAW has one or more determined lateral plate modes.

5. The BAW device (100) according to one of the claims 1 to 4, further comprising:
an acoustic reflective element (203) located below the top electrodes (103a, 103b), the piezoelectric layer (101), and the bottom electrodes (102b, 102b).

6. The BAW device according to claim 5, wherein:
the acoustic reflective element (203) comprises a plurality of high and low acoustic impedance layers (203a, 203b), which form a Bragg mirror structure.

7. The BAW device (100) according to claim 5 or 6, wherein:
the acoustic reflective element (203) comprises a cavity.

## Patentansprüche

1. Vorrichtung für akustische Volumenwellen (BAW) (100), die Folgendes umfasst:
eine piezoelektrische Schicht (101), die derart konfiguriert ist, dass sich in ihr eine BAW ausbreitet;
eine erste untere Elektrode (102a) und eine zweite untere Elektrode (102b), die jeweils unterhalb der piezoelektrischen Schicht (101) bereitgestellt sind;
eine erste obere Elektrode (103a) und eine zweite obere Elektrode (103b), die jeweils auf der piezoelektrischen Schicht (101) bereitgestellt sind,
wobei die piezoelektrische Schicht (101) zwischen der ersten oberen Elektrode (103a) und der ersten unteren Elektrode (102a) derart eingeschlossen ist, dass ein erster BAW-Resonator gebildet wird, wobei der erste BAW-Resonator einen ersten Resonatorbereich umfasst, bei dem es sich um einen Bereich der piezoelektrischen Schicht (101) handelt, der sich zwischen der ersten oberen Elektrode (103a) und der ersten unteren Elektrode (102a) befindet, und
wobei die piezoelektrische Schicht (101) zwischen der zweiten oberen Elektrode (103b) und der zweiten unteren Elektrode (102b) derart eingeschlossen ist, dass ein zweiter BAW-Resonator gebildet wird, wobei der zweite BAW-Resonator einen zweiten Resonatorbereich umfasst, bei dem es sich um einen Bereich der piezoelektrischen Schicht (101) handelt, der sich zwischen der zweiten oberen Elektrode (103b) und der zweite unteren Elektrode (102b) befindet;
wobei die BAW-Vorrichtung (100) ferner Folgendes umfasst:
eine Struktur zur akustischen Kopplung (104), die auf der piezoelektrischen Schicht (101) zwischen der ersten oberen Elektrode (103a) und der zweiten oberen Elektrode (103b) angeordnet ist,
wobei die Struktur zur akustischen Kopplung (104) derart konfiguriert ist, dass sich eine akustische Welle vom ersten Resonatorbereich durch die Struktur zur akustischen Kopplung (104) in den zweiten Resonatorbereich ausbreiten kann, und
wobei die BAW-Vorrichtung (100) **dadurch gekennzeichnet ist, dass** die Struktur zur akustischen Kopplung (104) eine Vielzahl von übereinander angeordneten Materialschichten (704a, 704b, 704c) umfasst.

2. BAW-Vorrichtung (100) nach Anspruch 1, wobei:
auf der ersten oberen Elektrode (103a) und auf der zweiten oberen Elektrode (103b) eine Massenbeladungsschicht (202) und/oder eine Passivierungsschicht (201) bereitgestellt ist, um jeweils einen ersten BAW-Stapel (103a, 201, 202) und einen zweiten BAW-Stapel (103b, 201, 202) zu bilden; und
die Struktur zur akustischen Kopplung (104) zwischen dem ersten BAW-Stapel (103a, 201, 202) und dem zweiten BAW-Stapel (103b, 201, 202) nach oben herausragt.

3. BAW-Vorrichtung (100) nach Anspruch 1, wobei:
auf der ersten oberen Elektrode (103a) und auf der zweiten oberen Elektrode (103b) eine Massenbeladungsschicht (202) und/oder eine Passivierungsschicht (201) bereitgestellt ist, um jeweils einen ersten BAW-Stapel (103a, 201, 202) und einen zweiten BAW-Stapel (103b, 201, 202) zu bilden; und
die Struktur zur akustischen Kopplung (104) zwischen dem ersten BAW-Stapel (103a, 201, 202) und dem zweiten BAW-Stapel (103b, 201, 202) eingelassen ist.

4. BAW-Vorrichtung (100) nach einem der Ansprüche 1 bis 3, wobei:
eine Dicke und/oder Breite der Struktur zur akustischen Kopplung (104) derart gewählt sind, dass die seitliche BAW einen oder mehrere bestimmte seitliche Plattenmodi aufweist.

5. BAW-Vorrichtung (100) nach einem der Ansprüche 1 bis 4, die ferner Folgendes umfasst:
ein Element zur akustischen Reflexion (203), das sich unterhalb der oberen Elektroden (103a, 103b), der piezoelektrischen Schicht (101) und der unteren Elektroden (102b, 102b) befindet.

6. BAW-Vorrichtung nach Anspruch 5, wobei:
das Element zur akustischen Reflexion (203) eine Vielzahl von Schichten mit hoher und niedriger akustischer Impedanz (203a, 203b) umfasst, die eine Bragg-Spiegel-Struktur bilden.

7. BAW-Vorrichtung (100) nach Anspruch 5 oder 6, wobei:
das Element zur akustischen Reflexion (203) einen Hohlraum umfasst.

## Revendications

1. Dispositif à ondes acoustiques de volume, BAW, (100), comprenant :
une couche piézoélectrique (101) configurée pour propager une BAW ;
une première électrode inférieure (102a) et une seconde électrode inférieure (102b) pourvues respectivement sous la couche piézoélectrique (101) ;
une première électrode supérieure (103a) et une seconde électrode supérieure (103b) pourvues respectivement sur la couche piézoélectrique (101),
dans lequel la première électrode supérieure (103a) et la première électrode inférieure (102a) prennent en sandwich la couche piézoélectrique (101) pour former un premier résonateur BAW, le premier résonateur BAW comprenant une première région de résonateur, qui est une région de la couche piézoélectrique (101) située entre la première électrode supérieure (103a) et la première électrode inférieure (102a), et
dans lequel la seconde électrode supérieure (103b) et la seconde électrode inférieure (102b) prennent en sandwich la couche piézoélectrique (101) pour former un second résonateur BAW, le second résonateur BAW comprenant une seconde région de résonateur, qui est une région de la couche piézoélectrique (101) située entre la seconde électrode supérieure (103b) et la seconde électrode inférieure (102b) ;
le dispositif BAW (100) comprenant également :
une structure de couplage acoustique (104) disposée entre la première électrode supérieure (103a) et la seconde électrode supérieure (103b) sur la couche piézoélectrique (101),
dans lequel la structure de couplage acoustique (104) est configurée pour permettre à une onde acoustique de se propager de la première région de résonateur à la seconde région de résonateur à travers la structure de couplage acoustique (104), et
le dispositif BAW (100) étant **caractérisé en ce que** la structure de couplage acoustique (104) comprend une pluralité de couches de matériaux (704a, 704b, 704c) disposées les unes sur les autres.

2. Dispositif BAW (100) selon la revendication 1, dans lequel :
une couche de charge massique (202) et/ou une couche de passivation (201) est pourvue sur la première électrode supérieure (103a) et sur la seconde électrode supérieure (103b) pour former respectivement une première pile BAW (103a, 201, 202) et une seconde pile BAW (103b, 201, 202) ; et
la structure de couplage acoustique (104) fait saillie entre la première pile BAW (103a, 201, 202) et la seconde pile BAW (103b, 201, 202) dans une direction ascendante.

3. Dispositif BAW (100) selon la revendication 1, dans lequel :
une couche de charge massique (202) et/ou une couche de passivation (201) est pourvue sur la première électrode supérieure (103a) et sur la seconde électrode supérieure (103b) pour former respectivement une première pile BAW (103a, 201, 202) et une seconde pile BAW (103b, 201, 202) ; et
la structure de couplage acoustique (104) est encastrée entre la première pile BAW (103a, 201, 202) et la seconde pile BAW (103b, 201, 202).

4. Dispositif BAW (100) selon l'une quelconque des revendications 1 à 3, dans lequel :
une épaisseur et/ou une largeur de la structure de couplage acoustique (104) sont sélectionnées de telle sorte que la BAW latérale a un ou plusieurs modes de plaque latérale déterminés.

5. Dispositif BAW (100) selon l'une quelconque des revendications 1 à 4, comprenant également :
un élément réfléchissant acoustique (203) situé sous les électrodes supérieures (103a, 103b), la couche piézoélectrique (101) et les électrodes inférieures (102b, 102b).

6. Dispositif BAW selon la revendication 5, dans lequel :
l'élément réfléchissant acoustique (203) comprend une pluralité de couches à impédance acoustique élevée et faible (203a, 203b), qui forment une structure de miroir de Bragg.

7. Dispositif BAW (100) selon la revendication 5 ou 6, dans lequel :
l'élément réfléchissant acoustique (203) comprend une cavité.
